# EUROPÄISCHE PATENTSCHRIFT

(11) **EP 3 336 569 B1**
(45) Veröffentlichungstag und Bekanntmachung des Hinweises auf die Patenterteilung: **14.07.2021**
(21) Anmeldenummer: 17204831.6
(22) Anmeldetag: 01.12.2017
(51) Int. Cl.: G01R 33/48, G01R 33/46, G01R 33/36, G01R 33/561

(54) **VERFAHREN ZUR MAGNETRESONANZUNTERSUCHUNG EINES MESSOBJEKTS UND HOCHFREQUENZEINHEIT EINES MAGNETRESONANZGERÄTES**
METHOD FOR MAGNETIC RESONANCE EXAMINATION OF AN OBJECT TO BE MEASURED AND HIGH FREQUENCY UNIT OF A MAGNETIC RESONANCE DEVICE
PROCÉDÉ D'EXAMEN PAR RÉSONANCE MAGNÉTIQUE D'UN OBJET DE MESURE ET UNITÉ HAUTE FRÉQUENCE D'UN APPAREIL D'IMAGERIE PAR RÉSONANCE MAGNÉTIQUE

(30) Priorität: 02.12.2016 DE 102016014340
(43) Veröffentlichungstag der Anmeldung: 20.06.2018
(73) Patentinhaber: Albert-Ludwigs-Universität Freiburg, 79098 Freiburg (DE)
(72) Erfinder: ÖZEN, Ali Caglar, 79199 Kirchzarten (DE); BOCK, Michael, 69126 Heidelberg (DE)
(74) Vertreter: Börjes-Pestalozza, Henrich

(56) Entgegenhaltungen:
- SALIM ET AL.: "DETECTION OF MR SIGNAL DURING RF EXCITATION USING FULL DUPLEX RADIO SYSTEM", INTERNATIONAL SOCIETY FOR MAGNETIC RESONANCE IN MEDICINE, ISMRM, 2030 ADDISON STREET, 7TH FLOOR, BERKELEY, CA 94704 USA, Nr. 3636, 22. April 2016 (2016-04-22), XP040684676,
- DINESH BHARADIA ET AL: "Full duplex radios", SIGCOMM, ACM, 2 PENN PLAZA, SUITE 701 NEW YORK NY 10121-0701 USA, 27. August 2013 (2013-08-27), Seiten 375-386, XP058030650, DOI: 10.1145/2486001.2486033 ISBN: 978-1-4503-2056-6
- MAYANK JAIN ET AL: "Practical, real-time, full duplex wireless", PROCEEDINGS OF THE 17TH ANNUAL INTERNATIONAL CONFERENCE ON MOBILE COMPUTING AND NETWORKING, MOBICOM '11, 1. Januar 2011 (2011-01-01), Seite 301, XP055309219, New York, New York, USA DOI: 10.1145/2030613.2030647 ISBN: 978-1-4503-0492-4
- SUNG-MIN SOHN ET AL: "In vivo MR imaging with simultaneous RF transmission and reception : In Vivo MR Imaging with STAR", MAGNETIC RESONANCE IN MEDICINE., Bd. 76, Nr. 6, 1. Dezember 2016 (2016-12-01), Seiten 1932-1938, XP055472496, US ISSN: 0740-3194, DOI: 10.1002/mrm.26464
- ÖZEN ET AL.: "In vivo MRI with Concurrent Excitation and Acquisition using Dynamic Analog Cancellation with Real-time Feedback", INTERNATIONAL SOCIETY FOR MAGNETIC RESONANCE IN MEDICINE, ISMRM, 2030 ADDISON STREET, 7TH FLOOR, BERKELEY, CA 94704 USA, Nr. 1047, 7. April 2017 (2017-04-07), XP040688615,

## Beschreibung

Die Erfindung betrifft ein Verfahren zur Magnetresonanzuntersuchung eines Messobjekts und eine Hochfrequenz(HF)-Einheit eines Magnetresonanz(MR)-Geräts wie beispielsweise eines MR-Tomographen oder NMR-Spektrometers. Bei dem Messobjekt kann es sich um einen Patienten handeln, aber auch um nicht-biologisches Material wie beispielsweise ein Ölfeld.

Heutzutage werden fast ausschließlich Messsequenzen verwendet, bei denen möglichst vermieden wird, ein MR-Signal aufzunehmen, während gleichzeitig ein MR-Signal in das Messobjekt eingestrahlt wird.

Hintergrund dieser üblicherweise anzutreffenden Trennung von Signalsendung und Signalempfang ist, dass hierdurch vermieden wird, dass das Empfangssignal einen dessen Qualität beeinträchtigenden Sendesignalanteil aufweist.

Bereits in den Anfängen der MR-Technologie hat sich gezeigt, dass es technologisch höchst anspruchsvoll ist, ein qualitativ hochwertiges MR-Signal zu erhalten, wenn Daten während der Signalerzeugung aufgenommen werden. Während bei den ersten Messungen in der MR-Tomographie (MRT) in den 1970ern noch die sog. Continuous-Wave-Methode angewendet wurde, haben sich in der MRT rasch gepulste Messsequenzen durchgesetzt.

Es besteht allerdings ein Bedürfnis nach praktisch anwendbaren Messsequenzen, bei denen zur gleichen Zeit ein MR-Signal gesendet wird und eine MR-Signalantwort aufgenommen wird. Eine Art solcher Sequenzen ist als CEA-Sequenz bekannt, wobei CEA ein Akronym für "concurrent excitation and acquisition" darstellt. Aktuell liefern solche Messsequenzen jedoch häufig keine ausreichende Qualität.

Ein Grund für die aktuell häufig nicht ausreichende Qualität liegt darin begründet, dass ein Signal, welches während der Signalanregung aufgenommen wird, zwangsläufig einen Sendesignalanteil aufweist, da eine vollständige Entkopplung von Sende- und Empfangsspule nicht möglich ist. Eine technologische Herausforderung besteht nun darin, diesen Sendesignalanteil in dem aufgenommenen Empfangssignal so weit wie möglich zu reduzieren. Günstig ist eine Reduktion von etwa 100 dB, da das Sendesignal häufig eine Signalintensität aufweist, welche um diesen hohen Wert höher ist als die geringe Signalintensität der von dem Messobjekt ausgestrahlten Signalantwort. Derart hohe Reduktionswerte sind in der MR-Technologie bislang unerreicht.

Mit den bislang in der MR-Technologie bekannten, auch kumulativ anwendbaren Methoden wie insbesondere einer geometrischen Entkopplung von Sende- und Empfangsspule oder einer digitalen Signalauslöschung sind Reduktionen von etwa 70dB erreichbar.

Die Erfindung betrifft ein aus dem Stand der Technik vorbekanntes Verfahren zur Magnetresonanzuntersuchung eines Messobjekts, wobei ein üblicherweise ein HF-Signal definierendes Sendesignal in das Messobjekt eingestrahlt wird und ein Antwortsignal, welches in Reaktion auf das Sendesignal von dem Messobjekt ausgestrahlt wird, aufgenommen wird. Das Sendesignal kann hierbei durch eine HF-Sendespule erzeugt werden und das Antwortsignal durch eine HF-Empfangsspule. Die HF-Empfangsspule kann auch mit der HF-Sendespule identisch sein. Zur Erzeugung einer Magnetisierung innerhalb eines Messobjekts kann das Messobjekt in ein Hauptmagnetfeld eingebracht werden. Vorzugsweise ist das Hauptmagnetfeld in einem Messbereich homogen und statisch. Es kann beispielsweise von einem vorzugsweise supraleitenden Hauptmagneten erzeugt sein, aber auch von einem Erdmagnetfeld oder einem sonstigen Magnetfeld gebildet sein.

Erfindungsgemäß ist ferner vorgesehen, dass das Antwortsignal zumindest zeitweilig während eines Einstrahlzeitraums des Sendesignals aufgenommen wird. Hierzu kann insbesondere eine bereits oben beschriebene CEA-Sequenz verwendet werden, aber auch jegliche sonstige, dem Fachmann bekannte oder von ihm entwickelbare Messsequenz, welche die beschriebene Eigenschaft aufweist. Erfindungsgemäß wird ein Messsignal durch Korrektur des Antwortsignals erzeugt. Auch dies ist grundsätzlich bekannt. So kann beispielsweise die bereits oben beschriebene Methode der digitalen Signalauslöschung verwendet werden, um die Qualität des aufgenommenen Antwortsignals zu verbessern. Aus dem Messsignal wird sodann erfindungsgemäß eine Information über das Messobjekt rekonstruiert wird. Bei der Information über das Messobjekt kann es sich insbesondere um ein Magnetresonanzspektrum und/oder ein Magnetresonanzbild handeln.

Zur Ausführung eines Verfahrens zur MR-Untersuchung eines Messobjekts ist eine Hochfrequenzeinheit bekannt mit einem Generator zur Generierung eines Hochfrequenzsignals, einem Signalteiler, welcher mit einem Ausgang des Generators in Wirkverbindung steht und der einen ersten Ausgang und einen zweiten Ausgang aufweist, einer Sendespule, mit der ein Sendesignal erzeugbar ist und die mit dem ersten Ausgang des Signalteilers in Wirkverbindung steht, einer Empfangsspule, mit der ein ein Magnetresonanzsignal bildendes Antwortsignal von einem Messobjekt aufnehmbar ist, einem Modulator, der mit dem zweiten Ausgang des Signalteilers in Wirkverbindung steht, wobei der Modulator einen Phasenmodulator und/oder einen Amplitudenmodulator umfasst und einem Signalkombinierer, welcher mit der Empfangsspule und dem Modulator in Wirkverbindung steht und mit dem ein Messsignal erzeugbar ist. Bei dem Signalkombinierer kann es sich beispielsweise um einen Leistungskoppler handeln.

Ein Verfahren und eine Hochfrequenzeinheit der oben beschriebenen Art sind bekannt, weisen jedoch insbesondere die zuvor beschriebenen Nachteile auf.

Aus dem Konferenzbeitrag Proc. Intl. Soc. Mag. Reson. Med. 24 (2016), 3636 ist eine Methode zur Detektion eines Magnetresonanzsignals während einer Anregung mit einem Radiofrequenzsignal bekannt. Es wird nach einer Phasen- und Amplitudenanpassung von dem Empfangssignal eine Kopie des Transmittersignals subtrahiert. Zur Feineinstellung wird ein Netzwerkanalysator verwendet.

Aus dem Konferenzbeitrag zur SIGCOMM'13, August 12-16, 2013, Hongkong, China, Seiten 375 bis 386 ist ein Design und eine Implementierung eines *inband full duplex WiFi radio* bekannt, bei dem auf demselben Kanal gesendet und empfangen wird. Beschrieben ist eine Methode zur analogen Reduktion von Selbstinterferenzen in Differenzen des Transmitsignals auf das Empfangssignal. In dem Beitrag ist weiter eine Methode zur dynamischen Anpassung der Kalibration beschrieben. Hierbei wird eine WiFi-Präambel ausgesendet und deren Frequenzantwort gemessen.

Der Konferenzbeitrag zur MOBICOM'11, 1. Januar 2011, Seiten 301 ff. offenbart ein *full duplex radio design* mit Signalinversion adaptiver Signalauslöschung.

Der Artikel Magn. Reson. Med. 76: 1932-1938 (2016) offenbart eine Methode zur simultanen Transmission und Empfang von Radiofrequenz-Signalen zur Magnetresonanzbildgebung in vivo. Es ist beschrieben, dass ein Ausgangssignal eines Transmitters geteilt wird in ein Sendesignal und in ein Kopplungssignal. Das Kopplungssignal wird gefiltert, es werden Gain und Phase angepasst und sodann mit dem Messsignal kombiniert. Gain und Phase werden hierbei manuell eingestellt.

Der Erfindung liegt die Aufgabe zugrunde, ein Verfahren zur Magnetuntersuchung eines Messobjekts und eine Hochfrequenzeinheit eines MR-Geräts zu schaffen, so dass qualitativ hochwertige Informationen über das Messobjekt geliefert werden können.

Zur Lösung dieser Aufgabe schlägt die Erfindung die Merkmale von Anspruch 1 vor. Insbesondere wird somit erfindungsgemäß bei einem Verfahren der oben beschriebenen Art vorgeschlagen, dass ein dem Sendesignal korrespondierendes Korrektursignal erzeugt wird. Eine Korrespondenz liegt beispielsweise vor, wenn der Informationsgehalt des Korrektursignals und des Sendesignals übereinstimmen oder wenn die Signale ineinander überführbar sind. Dies ist insbesondere der Fall, wenn sich das Sendesignal und das Korrektursignal lediglich in einer Amplitude und/oder Phase und/oder Frequenz unterscheiden. Korrespondierende Signale können beispielsweise erzeugt werden, wenn ein von einem HF-Generator erzeugtes HF-Signal in einem Leistungsteiler in ein zu einer Sendespule übermitteltes Transmitsignal und ein im Vergleich zum Transmitsignal in einer Signalamplitude moduliertes Korrektursignal aufgespalten wird.

Erfindungsgemäß wird das Korrektursignal zur Korrektur des Antwortsignals verwendet, wobei das Korrektursignal durch einen Phasenwert und einen Amplitudenwert moduliert wird. Die Korrektur kann insbesondere durch einen Phasenmodulator und/oder einen Amplitudenmodulator erfolgen.

Erfindungsgemäß werden zur Korrektur des Antwortsignals folgende Schritte automatisch iterativ ausgeführt:
In einem ersten Schritt wird ein aktueller Zustandswerts des Messsignals ermittelt.

In einem zweiten Schritt wird ein aktueller Phasenwert und/oder ein aktueller Amplitudenwert für das Korrektursignal ermittelt. Hierzu wird ein Optimierungsverfahren verwendet, wobei das Optimierungsverfahren den aktuellen Zustandswert des Messsignals als Input verwendet.

In einem dritten Schritt wird ein einem aktuellen Abschnitt des Sendesignals korrespondierender aktueller Abschnitt des Korrektursignals mit dem aktuellen Phasenwert und/oder dem aktuellen Amplitudenwert moduliert. Bei dem aktuellen Abschnitt des Sendesignals und des korrespondierenden Korrektursignals kann es sich jeweils um ein Signal einer bestimmten Dauer handeln. In Betracht kommt beispielsweise ein Signalimpuls einer bestimmten Dauer.

In einem vierten Schritt wird ein aktueller Abschnitt des Messsignals durch Subtraktion des aktuellen Abschnitts des Korrektursignals von einem zeitgleich zum Einstrahlen des aktuellen Abschnitts des Sendesignals aufgenommenen aktuellen Abschnitt des Antwortsignals erzeugt. Die Subtraktion kann beispielsweise mittels eines Signalkombinierers erfolgen.

Die soeben beschriebene automatisch erfolgende iterative Korrektur hat den großen Vorteil, dass hierdurch eine effektive Unterdrückung eines störenden Sendesignalanteils im Messsignal ermöglicht wird. Insbesondere durch Kombination dieses Korrekturverfahrens mit bereits bekannten Methoden kann hierdurch eine Signalunterdrückung von bis zu 100 dB oder sogar darüber hinaus erreicht werden. Hierdurch wird ein MR-Untersuchungsverfahren geschaffen, mit dem qualitativ hochwertige Messdaten geliefert werden können.

Hierdurch kann eine MR-Untersuchung mittels ungepulster Messsequenzen durchgeführt werden. Dies ermöglicht eine Reihe neuer Anwendungen mit hervorragenden Eigenschaften. Beispielsweise sind ungepulste Sequenzen leise, mit ihnen ist eine Akquisitionseffizienz auf bis zu 100% steigerbar und Messungen von MR-Signalen von Messobjekten mit ultra-kurzen T2-Zeiten werden ermöglicht.

Zur Durchführung des Verfahrens kann vorgesehen sein, dass die soeben beschriebenen Schritte während einer MR-Untersuchung zumindest einmal, im Regelfall jedoch mehrfach durchgeführt werden. Weiter kann vorgesehen sein, dass vor der Ausführung der soeben beschriebenen Schritte eine Initialisierung erfolgt.

Bei einer vorteilhaften Ausgestaltung des Verfahrens kann vorgesehen sein, dass der Zustandswert des Messsignals ein Maß für einen Sendesignalanteil in dem Messsignal ist. Dies kann vorteilhaft sein, da es gerade ein Ziel der Korrektur ist, einen Sendesignalanteil in dem Messsignal zu reduzieren. Es ist daher zweckmäßig, ein Maß hierfür in das Optimierungsverfahren einzuführen. Alternativ oder zusätzlich kann vorgesehen sein, dass der Zustandswert des Messsignals ein Maß für eine Signalstärke des Messsignals ist. Das Maß kann beispielsweise durch eine p2-Norm eines Abschnitts des Messsignals gebildet sein. Dies ist einfach umsetzbar, da das analoge Messsignal oder Datenpunkte des Messsignals in digitalisierter Form üblicherweise leicht zugänglich sind. Als Abschnitt des Messsignals kann insbesondere ein zuvor, vorzugsweise zuletzt, erzeugter Abschnitt des Messsignals verwendet werden. Die Verwendung eines Maßes für die Signalstärke des Messsignals hat den Vorteil, dass die Signalstärke unmittelbar verfügbar ist. Sie kann häufig zugleich auch ein Maß für einen Sendesignalanteil in dem Messsignal bilden, da dieser Anteil regelmäßig die Signalintensität deutlich stärker bestimmt als das eigentlich interessierende von dem Messobjekt ausgestrahlte Signal.

Bei einer weiteren vorteilhaften Ausgestaltung des Verfahrens kann vorgesehen sein, dass das Optimierungsverfahren mindestens einen weiteren zuvor, insbesondere zuletzt, ermittelten Zustandswert des Messsignals als Input verwendet. Von besonderem Interesse sind dabei der zuletzt ermittelte Zustandswert oder die zuletzt ermittelten Zustandswerte. Die Einbeziehung weiterer Information kann ausgenutzt werden, um die Korrektur des Antwortsignals zu verbessern.

Es kann vorteilhaft sein, wenn alternativ oder zusätzlich der jeweils aktuelle Phasenwert und/oder der jeweils aktuelle Amplitudenwert mittels eines Gradientenverfahrens ermittelt wird.

Hierbei ist zu beachten, dass ein zu minimierendes Zielfunktional für das Gradientenverfahren regelmäßig nicht a priori bekannt ist, jedoch punktuell gemessen und somit geschätzt werden kann. So kann beispielsweise als zu minimierendes Zielfunktional der Zustandswert gewählt werden. Eine Steigung des Zielfunktionals kann numerisch geschätzt werden, indem Informationen über einen oder mehrere bereits zuvor ermittelte Zustandswerte des Messsignals verwertet werden.

Zur Durchführung eines schnellen, effektiven und praktikablen Gradientenverfahrens kann beispielsweise vorgesehen sein, dass in jeder Iteration eine Größe, von der der Phasenwert und/oder der Amplitudenwert abhängt, verändert wird. Die Größe kann der Phasenwert und/oder der Amplitudenwert selbst sein, aber beispielsweise auch eine Spannung. So kann beispielsweise ein Modulator mit der Spannung versorgt werden, wobei der Modulator eine Phasenmodulation des Korrektursignals mit dem Phasenwert und/oder eine Amplitudenmodulation des Korrektursignals mit dem Amplitudenwert elektronisch umsetzen kann. Weiter kann bei dem Gradientenverfahren vorgesehen sein, dass ausgelesen wird, in welcher Richtung die Größe in einer vorherigen Iteration verändert worden ist, dass weiterhin für eine Veränderung der Größe eine Schrittweite gewählt wird, dass weiterhin der aktuelle Zustandswert des Messsignals mit einem oder dem zuvor ermittelten Zustandswert verglichen wird und für den Fall einer Verbesserung des Zustandswerts die Veränderung der Größe in der ausgelesenen Richtung erfolgt und für den Fall einer Verschlechterung des Zustandswert die Veränderung der Größe in einer der ausgelesenen Richtung entgegengesetzten Richtung erfolgt. Bei der Wahl der Schrittweite kann es zweckmäßig sein, wenn die Schrittweite von Iteration zu Iteration monoton fallend gewählt wird.

Um mit möglichst wenigen Iterationen ein möglichst gute Korrektur zu erreichen, kann auch vorgesehen sein, dass in dem Optimierungsverfahren in einem ersten Schritt ein optimaler Phasenwert ermittelt wird, bevor in einem zweiten Schritt ein optimaler Amplitudenwert ermittelt wird. Eine Optimierung kann auch abwechselnd erfolgen.

Um eine möglichst hohe Akquisitionseffizienz zu erzielen, kann bei einer weiteren vorteilhaften Ausgestaltung des Verfahrens vorgesehen sein, dass das Antwortsignal vollständig während des Einstrahlzeitraums des Sendesignals aufgenommen wird. Alternativ oder zusätzlich kann vorgesehen sein, dass eine CEA-Sequenz verwendet wird. Alternativ oder zusätzlich kann vorgesehen sein, dass die Information über das Messobjekt aus dem Messsignal rekonstruiert wird, indem mindestens 90%, vorzugsweise 100%, einer gesamten Aufnahmedauer des Messsignals verwertet wird.

Bei einer weiteren vorteilhaften Ausgestaltung des Verfahrens kann vorgesehen sein, dass das Modulieren des dem aktuellen Abschnitt des Sendesignals korrespondierenden aktuellen Abschnitts des Korrektursignals mit dem aktuellen Phasenwert und/oder dem aktuellen Amplitudenwert spanungsgesteuert erfolgt. Dies kann den Vorteil haben, dass hierdurch eine effektive elektronische und automatisierte Umsetzung der Korrektur ermöglicht wird. Vorteilhaft kann es sein, wenn dies unter Verwendung eines spannungsgesteuert verstellbaren, vorzugsweise analog betriebenen, Phasenmodulators und/oder spannungsgesteuert verstellbaren, vorzugsweise analog betriebenen, Amplitudenmodulators erfolgt. Besonders vorteilhaft kann es sein, wenn in einem bei der MR-Untersuchung durchfahrenen Bereich eine Phasen-Spannungs-Kennlinie des Phasenmodulators und/oder eine Amplituden-Spannungs-Kennlinie und/oder eine Dämpfungs-Spannungs-Kennlinie des Amplitudenmodulators monoton oder streng monoton oder sogar linear ist. Der Verlauf der Kennlinien kann steigend oder fallend sein. Linearität kann vorteilhaft sein. Eine Nicht-Linearität kann bei der Optimierung durch Verwendung variabler Schrittweiten kompensiert werden. Alternativ oder zusätzlich kann vorgesehen sein, dass eine Spannungssteuerung digital erfolgt. Eine digitale Steuerung hat den Vorteil, dass das Optimierungsverfahren mittels eines PCs oder eines Mikroprozessors durchführbar ist, wobei das Optimierungsverfahren als Outputdaten digitale Steuerungsdaten wie beispielsweise Spannungswerte liefern kann.

Bei einer weiteren vorteilhaften Ausgestaltung des Verfahrens kann vorgesehen sein, dass zur Subtraktion des aktuellen Abschnitts des Korrektursignals von dem zeitgleich zum Einstrahlen des aktuellen Abschnitts des Sendesignals aufgenommenen aktuellen Abschnitt des Antwortsignals ein Signalkombinierer, vorzugsweise ein Leistungskoppler, verwendet wird. Mit dem Signalkombinierer sind Signale miteinander kombinierbar. Der Signalkombinierer ist daher zur Subtraktion von Signalen optimal geeignet.

Bei einer weiteren vorteilhaften Ausgestaltung des Verfahrens kann vorgesehen sein, dass zur Verstärkung des Messsignals ein Signalverstärker verwendet wird, wobei der Signalverstärker eine dynamische Bandbreite hat, welche außerhalb einer Signalstärke des amplitudenmodulierten Korrektursignals liegt. Besonders vorteilhaft ist es, wenn die Signalstärke des Korrektursignals und/oder des Antwortsignals die dynamische Bandbreite des Verstärkers überschreitet. Es kann auch gesagt werden, dass die Signalstärke des Korrektursignals und/oder des Antwortsignals zumindest so stark ist, dass der Verstärker gesättigt wird. Auch wenn dies auf den ersten Blick nachteilhaft erscheint, da der Verstärker in diesem Fall nicht dazu in der Lage ist, ein nicht ausreichend korrigiertes Messsignal zu verarbeiten, erwächst hieraus jedoch zugleich der Vorteil, dass ein Verstärker mit geringer dynamischer Bandbreite verwendbar ist, sodass das jeweilige Gerät kostengünstig ist und/oder eine hohe Güte aufweist.

Eine besonders gute Signalkorrektur ist möglich bei einer weiteren vorteilhaften Ausgestaltung des Verfahrens, bei der ferner vorgesehen ist, dass zunächst der Zustandswert des Messsignals geprüft wird und dass bei Überschreiten eines ersten Grenzwertes die zur Korrektur des Antwortsignals durchzuführenden Schritte ausgeführt werden bis der Zustandswert des Messsignals einen zweiten Grenzwert erreicht hat. Die Prüfung des zunächst geprüften Zustandswerts des Messsignals kann einmal, regelmäßig mehrfach, insbesondere in regelmäßigen Zeitabständen, während einer MR-Messung und/oder MR-Untersuchung erfolgen. Die beiden Grenzwerte können unterschiedlich oder auch identisch sein. Besonders vorteilhaft kann es sein, wenn der erste und/oder der zweite Grenzwert größer ist als ein Schätzwert für einen maximalen Zustandswerts des Messsignals. Der Grenzwert kann den Schätzwert beispielsweise um mindestens 0%, 10%, 50% oder mindestens 100 % übersteigen. Ein solcher Schätzwert kann sich aus theoretischen Überlegungen ergeben oder auch auf einer Messung beruhen, beispielsweise unter Anwendung eines Sequenzabschnitts, bei dem ein maximaler Zustandswert zu erwarten ist.

Besonders vorteilhaft kann es hierbei sein, wenn es sich bei dem maximalen Zustandswert des Messsignals um einen Wert handelt, bei dem das Messsignal keinen Sendesignalanteil aufweist. Handelt es sich bei dem maximalen Zustandswert um eine Signalstärke, so kann zu dessen Ermittlung zunächst eine Messung ohne Messobjekt durchgeführt werden und sodann eine Messung mit Messobjekt. Aus der Differenz von miteinander korrespondierenden Signalabschnitten aus beiden Messungen kann sodann ein Schätzwert für den maximalen Zustandswert ermittelt werden. Alternativ kann beispielsweise auch ein off-resonanter Sendeimpuls in das Messobjekt eingestrahlt werden, welcher die Spins nicht wesentlich anregt, jedoch eine unerwünschte Einkopplung des Sendeimpulses in der Empfangsspule liefert. Eine Kenntnis über die Frequenzabhängigkeit des Sendesignalanteils in dem Messsignal kann sodann genutzt werden, um durch Extrapolation auf geeignete, insbesondere on-resonante, Frequenzen einen Schätzwert für den maximalen Zustandswert zu erhalten. Dies kann erforderlich sein, da häufig die Empfangsspule bei einer off-Resonanz anders reagiert als bei einer on-Resonanz, so dass noch auf die on-resonante Antwort zu schließen ist. Dies kann beispielsweise vor der eigentlichen Messung durch Kalibration erfolgen.

Um eine maximale Akquisitionseffizienz zu erzielen, kann bei einer weiteren vorteilhaften Ausgestaltung des Verfahrens vorgesehen sein, dass der jeweils aktuelle Abschnitt des Messsignals auch zur Rekonstruktion der Information über das Messobjekt verwendet wird. In diesem Fall benötigt die Anwendung der Verfahrensschritte zur Korrektur des Antwortsignals keine zusätzliche Zeit.

Alternativ kann vorgesehen sein, dass der jeweils aktuelle Abschnitt des Messsignals nicht zur Rekonstruktion der Information über das Messobjekt verwendet wird. Hierdurch werden zwar potentiell für die Korrektur des Antwortsignals bei der Ausführung einer MR-Messung zusätzliche Zeitfenster benötigt. Allerdings kann bei dieser Methode kontrolliert und sichergestellt werden, dass jeder aufgenommene Messabschnitt auch eine den jeweiligen Anforderungen entsprechende Qualität aufweist. Es kann vorteilhaft sein, wenn der jeweils aktuelle Abschnitt des Messsignals eine Dauer aufweist, welche einer Impulsdauer eines Sendesignals entspricht, welches in das Messobjekt eingestrahlt wird, um einen zur Rekonstruktion verwendeten Abschnitt eines Messsignals zu erzeugen. Eine solche Korrektur lässt sich in vorteilhafter Weise in eine Messsequenz integrieren. Um die Messzeit zu reduzieren, kann es jedoch auch vorteilhaft sein, die Dauer des aktuellen Abschnitts des Messsignals auf einen Bruchteil, wie beispielsweise ein Fünftel, Zehntel oder Zwanzigstel, der oben genannten Impulsdauer zu begrenzen.

Um die Qualität der rekonstruierten Information über das Messobjekt zu erhöhen, kann bei einer weiteren Ausgestaltung des Verfahrens vorgesehen sein, dass für den Fall, dass der aktuelle Zustandswert des Messsignals einen dritten Grenzwert überschreitet, der zuletzt erzeugte Abschnitt des Messsignals erneut erzeugt wird. Hier kann vorgesehen sein, dass dies zum nächst möglichen Zeitpunkt nach Überschreitung des dritten Grenzwertes erfolgt oder auch zu einem späteren Zeitpunkt der MR-Untersuchung. Der dritte Grenzwert kann hierbei insbesondere mit dem ersten und/oder dem zweiten Grenzwert übereinstimmen.

Bei einer weiteren vorteilhaften Ausgestaltung des Verfahrens kann vorgesehen sein, dass ein on-resonanter Impuls in das Messobjekt eingestrahlt wird, um den aktuellen Abschnitt des Messsignals zu erzeugen. Bei dem on-resonanten Impuls kann es sich vorzugsweise um einen Rechteckimpuls handeln. Ein Vorteil der Applizierung eines on-resonanten Impulses besteht darin, dass hierbei kein A-priori-Wissen über die Größe des Sendesignalanteils an dem Antwortsignal benötigt wird. Dies kann anders sein, wenn beispielsweise ein für die Generierung von für die Rekonstruktion vorgesehenen Messdaten verwendeter Sweep-Sendeimpuls auch zur Korrektur des Antwortsignals verwendet werden soll, da bei einem solchen off-resonanten Sendeimpuls die oft frequenzabhängige Korrektur für jede offresonante Frequenz regelmäßig individuell berücksichtigt werden müsste.

Zur Lösung der genannten Aufgabe sind erfindungsgemäß die Merkmale des auf eine Hochfrequenzeinheit gerichteten nebengeordneten Anspruchs vorgesehen. Insbesondere wird zur Lösung der genannten Aufgabe somit erfindungsgemäß bei einer Hochfrequenzeinheit der oben beschriebenen Art vorgeschlagen, dass eine Steuereinheit ausgebildet ist, die mit dem Signalkombinierer und dem Modulator in Wirkverbindung steht und dass mit der Hochfrequenzeinheit das erfindungsgemäße Verfahren sowie die oben beschriebenen Ausgestaltungen des Verfahrens ausführbar sind. Bei der Steuereinheit kann es sich beispielsweise um eine Recheneinheit, insbesondere einen PC, handeln. Mit einer derart ausgebildeten Hochfrequenzeinheit können bei einer MR-Untersuchung qualitativ hochwertige Informationen über ein Messobjekt erhalten werden.

Die Erfindung wird nun anhand einiger weniger Ausführungsbeispiele näher beschrieben, ist jedoch nicht auf diese wenigen Ausführungsbeispiele beschränkt. Weitere Ausführungsbeispiele ergeben sich durch Kombination der Merkmale einzelner oder mehrerer Schutzansprüche untereinander und/oder mit einzelnen oder mehreren Merkmalen der Ausführungsbeispiele.

Es zeigt:
- Fig. 1: eine erfindungsgemäße Hochfrequenzeinheit eines Magnetresonanzgeräts,
- Fig. 2: ein vereinfachtes Schaltbild eines in Fig. 1 verwendbaren Phasenmodulators,
- Fig. 3: einen Verlauf des modulierenden Phasenwertes in Abhängigkeit von einer Eingangsspannung des Phasenmodulators gemäß Fig. 2,
- Fig. 4: einen Verlauf des modulierenden Phasenwertes in Abhängigkeit von einer Eingangsspannung eines alternativen Phasenmodulators,
- Fig. 5: ein vereinfachtes Schaltbild eines in Fig. 1 verwendbaren Amplitudenmodulators,
- Fig. 6: einen Verlauf des modulierenden Amplitudenwertes in Abhängigkeit von einer Eingangsspannung des Amplitudenmodulators gemäß Fig. 5,
- Fig. 7: ein vereinfachtes Schaltbild eines alternativen in Fig. 1 verwendbaren Amplitudenmodulators,
- Fig. 8: einen Verlauf des modulierenden Amplitudenwertes in Abhängigkeit von einer Eingangsspannung des Amplitudenmodulators gemäß Fig. 7,
- Fig. 9: ein Flussdiagramm eines erfindungsgemäßen Verfahrens zur MR-Untersuchung eines Messobjekts,
- Fig. 10: ein Sequenzdiagramm einer MR-Messung, bei der das in Fig. 9 dargestellte Verfahren zur Anwendung kommen kann,
- Fig. 11: ein Flussdiagramm eines alternativen erfindungsgemäßen Verfahrens zur MR-Untersuchung eines Messobjekts,
- Fig. 12: ein Sequenzdiagramm einer MR-Messung, bei der das in Fig. 11 dargestellte Verfahren zur Anwendung kommen kann,
- Fig. 13: ein Messdiagramm, welches das Konvergenzverhalten eines erfindungsgemäß ausgebildeten Korrekturverfahrens zeigt, wenn das untersuchte Messobjekt in einem MR-Tomographen bewegt wird.
- Fig. 14: ein alternatives Sequenzdiagramm einer erfindungsgemäßen MR-Untersuchung

Bei der nachfolgenden Beschreibung verschiedener Ausführungsbeispiele der Erfindung erhalten in ihrer Funktion übereinstimmende Elemente auch bei abweichender Gestaltung oder Formgebung übereinstimmende Bezugszahlen.

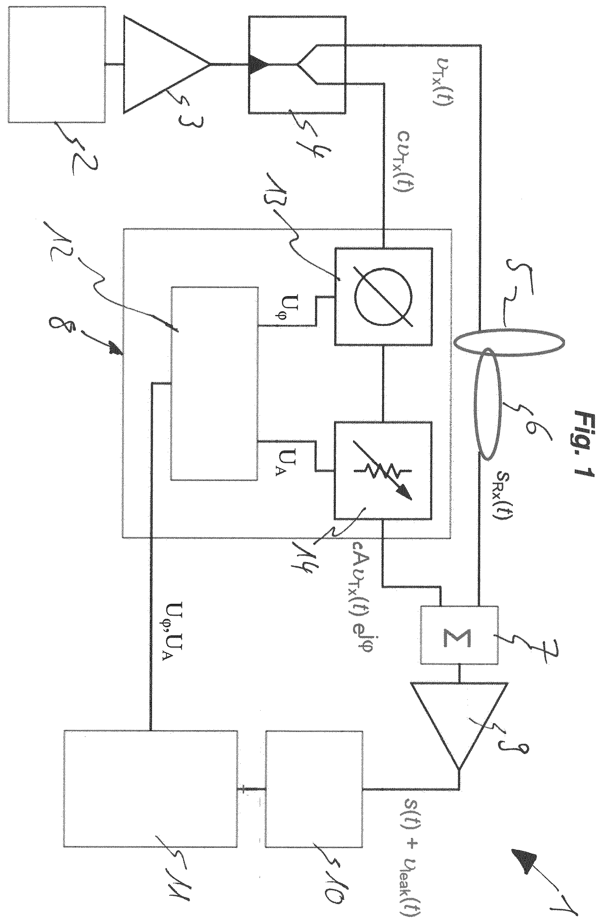

Fig. 1 zeigt eine erfindungsgemäße Hochfrequenzeinheit 1 eines nicht abgebildeten Magnetresonanzgeräts, mit der ein erfindungsgemäßes Verfahren ausführbar ist. Ein HF-Generator 2, mit dem ein HF-Signal erzeugbar ist, ist mit einem rauscharmen Signalverstärker 3 (low noise amplifier) verbunden, der das verstärkte HF-Signal an den Signalteiler 4 übermittelt. In dem Signalteiler 4 wird das HF-Signal aufgespalten in ein an die Sendespule 5 übermitteltes Transmitsignal v_{Tx}(t) und ein korrespondierendes Korrektursignal c*v_{Tx}(t). Das Korrektursignal hat den gleichen Signalverlauf wie das Transmitsignal, ist allerdings in der Amplitude mit dem Faktor c moduliert, beispielsweise mit c = 0,28.

Das Transmitsignal wird von der Sendespule 5 umgesetzt, so dass ein Sendesignal in ein Messobjekt (nicht abgebildet) einstrahlbar ist. Mit der Empfangsspule 6 ist sodann ein in Reaktion auf das Sendesignal von dem Messobjekt ausgestrahltes MR-Signal aufnehmbar. Ein mit der Empfangsspule 6 aufgenommenes Antwortsignal s_{Rx}(t) wird sodann an den Signalkombinierer 7 übermittelt. In dem Signalkombinierer 7 wird von dem Antwortsignal das von dem Modulator 8 modulierte Korrektursignal A*c*v_{Tx}(t)*e^{jϕ} subtrahiert. Das subtrahierte Signal wird sodann von dem ultrarauscharmen Signalverstärker 9 (ultra low noise amplifier) verstärkt. Das resultierende Messsignal s(t) + vₗₑₐₖ(t) wird an einen Analog-Digital-Wandler 10 übermittelt, der das Messsignal digitalisiert.

Das digitalisierte Messsignal wird sodann zu einer Recheneinheit 11 übermittelt. In dem hier beschriebenen Ausführungsbeispiel handelt es sich bei der Recheneinheit 11 um einen externen Personalcomputer (PC). Die von der Recheneinheit 11 durchzuführenden Berechnungen können jedoch beispielsweise auch von einer Rekonstruktionseinheit durchgeführt werden, welche auch die Rekonstruktion der gewünschten Information über das Messobjekt aus dem digitalisierten Messsignal, wie insbesondere eine Bildrekonstruktion, durchführt.

Die Recheneinheit 11 sendet das Rechenergebnis U_{ϕ},U_{A} an den Modulator 8. Bei den Größen U_{ϕ},U_{A} handelt es sich um Spannungswerte in digitaler Form, welche von dem Gleichspannungs-Stromversorgungsmodul 12 bereitgestellt werden kann. Das Gleichspannungs-Stromversorgungsmodul 12 versorgt einen analog betriebenen Phasenmodulator 13 mit der Spannung U_{ϕ} und den ebenfalls analog betriebenen Amplitudenmodulator 14 mit der Spannung U_{A}. Der mit der Spannung U_{ϕ} versorgte Phasenmodulator prägt dem Korrektursignal c*v_{Tx}(t) eine Phase ϕ auf und der mit der Spannung U_{A} versorgte Amplitudenmodulator moduliert das phasenverschobene Korrektursignal mit der Amplitude A, so dass im Ergebnis der Modulator 8 das modulierte Korrektursignal A*c*v_{Tx}(t)*e^{jϕ} an den bereits oben beschriebenen Signalkombinierer 7 liefert.

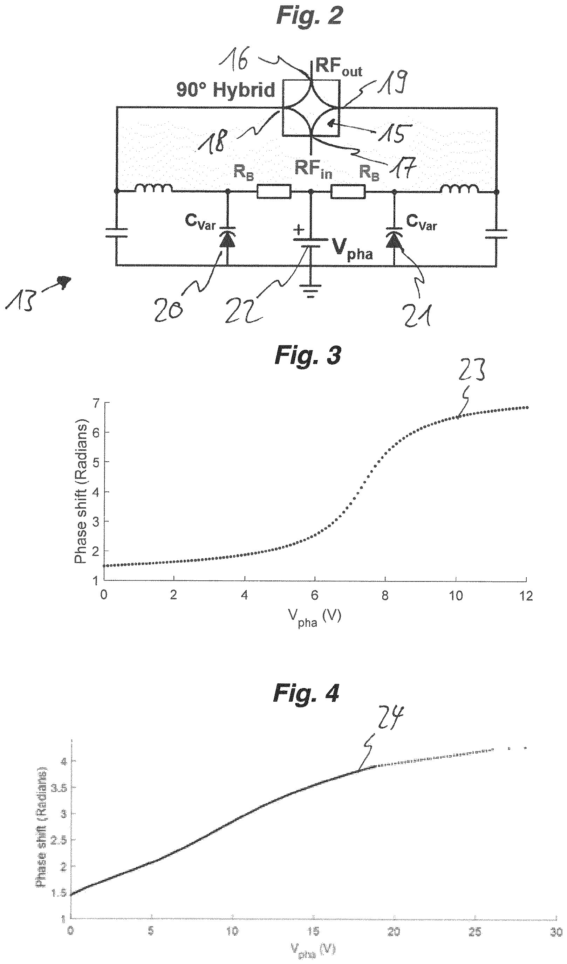

Fig. 2 zeigt ein vereinfachtes Schaltbild eines in Fig. 1 verwendbaren spannungsgesteuerten Phasenmodulators 13. Bei dem Phasenmodulator 13 handelt es sich um einen analogen Phasenschieber vom Reflektionstyp. Mit ihm kann einem an einem ersten Anschluss 16 eines 90°-Hybridkopplers 15 anliegenden Eingangssignal "RFᵢₙ" eine variable Phase ϕ aufgeprägt werden, so dass das Ausgangssignal "RFₒᵤₜ" an einem zweiten Anschluss 17 in Bezug zum Eingangssignal eine Phasenverschiebung von ϕ aufweist. Um dies zu erreichen, werden die Impedanzen an einem dritten Anschluss 18 und an einem vierten Anschluss 19 des 90°-Hybridkopplers variiert. Dies erfolgt durch die Verwendung von Varaktordioden 20, 21, deren jeweilige Kapazität C_{Var} anpassbar ist, indem die Spannung Vₚₕₐ einer Gleichspannungsquelle 22 verändert wird, beispielsweise mittels des Gleichspannungs-Stromversorgungsmoduls 12. In dem hier beschriebenen Ausführungsbeispiel ist C_{Var} monoton wachsend bezüglich der Spannung Vₚₕₐ. Bei 25 V kann C_{Var} beispielsweise 75 pF betragen.

Fig. 3 zeigt die mit dem in Fig. 2 abgebildeten Phasenmodulator 13 erzielte Phasenverschiebung in Abhängigkeit von der Steuerspannung Vₚₕₐ. Die in Fig. 3 gezeigte Phasen-Spannungs-Kennlinie 23 kann wichtig sein, wenn zwar gezielt eine bestimmte Phasenverschiebung erzielt werden soll, allerdings lediglich Spannungswerte Vₚₕₐ vorgebbar sind.

Fig. 4 zeigt die Phasen-Spannungs-Kennlinie 24 eines alternativen in Fig. 1 verwendbaren Phasenmodulators 13. Die Phasen-Spannungs-Kennlinie 24 ist wie die zuvor beschriebene Phasen-Spannungs-Kennlinie 23 streng monoton steigend und weist darüber hinaus einen nahezu linearen Verlauf auf. Der alternative Phasenmodulator 13 reagiert daher weniger empfindlich auf Spannungsänderungen als der in Fig. 2 gezeigte Phasenmodulator 13.

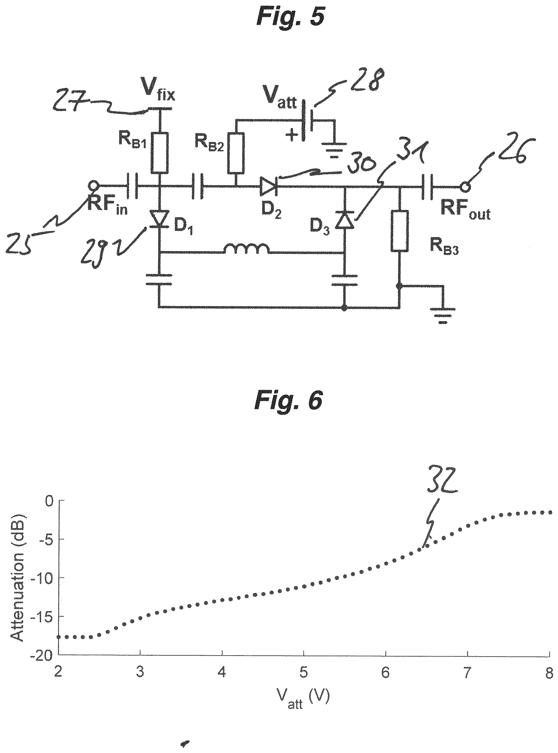

Fig. 5 zeigt ein vereinfachtes Schaltbild eines in Fig. 1 verwendbaren Amplitudenmodulators 14. Bei dem in Fig. 5 gezeigten Amplitudenmodulator 14 wird das an einem zweiten Anschluss 26 ausgehende Signal gegenüber einem an einem ersten Anschluss 25 eingehenden Signal gedämpft. Der Grad der Dämpfung ist einstellbar mittels einer Gleichspannungsquelle 27 mit unveränderlicher Spannung V_{fix} und einer Gleichspannungsquelle 28 mit veränderlicher Spannung Vₐₜₜ. Zur Verwendung des in Fig. 5 gezeigten Amplitudenmodulators 14 in der in Fig. 1 gezeigten HF-Einheit kann V_{fix} beispielsweise auf 4,5 V eingestellt werden und Vₐₜₜ kann beispielsweise zwischen 0 V und 8 V variiert werden. Der spannungsgesteuerte Amplitudenmodulator 14 basiert auf einem n-Netzwerk, welches von den drei pin-Dioden 29, 30 und 31 gebildet ist. Die pin-Dioden 29, 30 und 31 verhalten sich wie spannungsgesteuerte Widerstände. Wenn Vₐₜₜ erhöht wird, verringert sich der Widerstand in dem HF-Pfad zwischen dem ersten Anschluss 25 und dem zweiten Anschluss 26.

Fig. 6 zeigt eine Dämpfungs-Spannungs-Kennlinie 32, welche zu dem in Fig. 5 gezeigten Amplitudenmodulator 14 korrespondiert. Auf der y-Achse ist die Dämpfung ("Attenuation") in dB abgetragen, auf der x-Achse die eingestellte Spannung Vₐₜₜ in Volt. Wie aus Fig. 6 ersichtlich, weist die Dämpfungs-Spannungs-Kennlinie 32 einen monoton steigenden Verlauf auf, ist zwischen Vₐₜₜ = 2,5 V und V_{att°}=°8,0°V streng monoton und weist in diesem Bereich eine nahezu lineare Abhängigkeit der Dämpfung von der Spannung Vₐₜₜ auf.

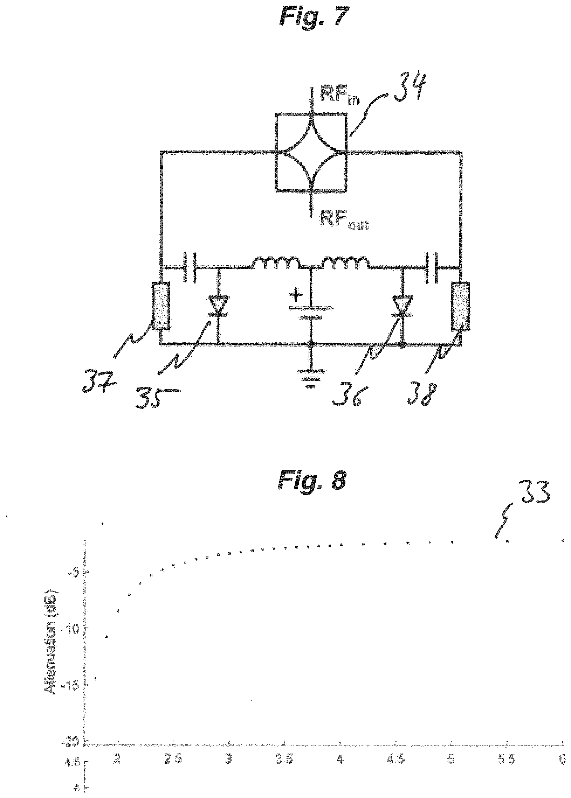

Fig. 7 zeigt ein vereinfachtes Schaltbild eines alternativen in Fig. 1 verwendbaren Amplitudenmodulators 14. Fig. 8 zeigt die korrespondierende streng monoton steigende Dämpfungs-Spannungs-Kennlinie 33. Bei dem in Fig. 7 gezeigten alternativen Amplitudenmodulator 14 handelt es sich um einen Dämpfer mit Hybridkoppler 34, welcher eine symmetrische Konfiguration aufweist. Der Amplitudenmodulator 14 ist abgestimmt ("matched"), so dass Reflexionen verhindert werden und die analoge Korrekturschaltung eine breitere Nutzbandbreite aufweist als der in Fig. 5 gezeigte Amplitudenmodulator 14. pin-Dioden 35, 36 wurden parallel verschaltet mit 50Ω-Widerständen 37, 38. Diese Konfiguration stellt bereits eine ausreichende Dämpfung zur Verfügung und ist weniger empfindlich auf Spannungsänderungen als der in Fig. 5 abgebildete Amplitudenmodulator 14 in einem Ausschnitt eines nutzbaren Dämpfungsbereichs.

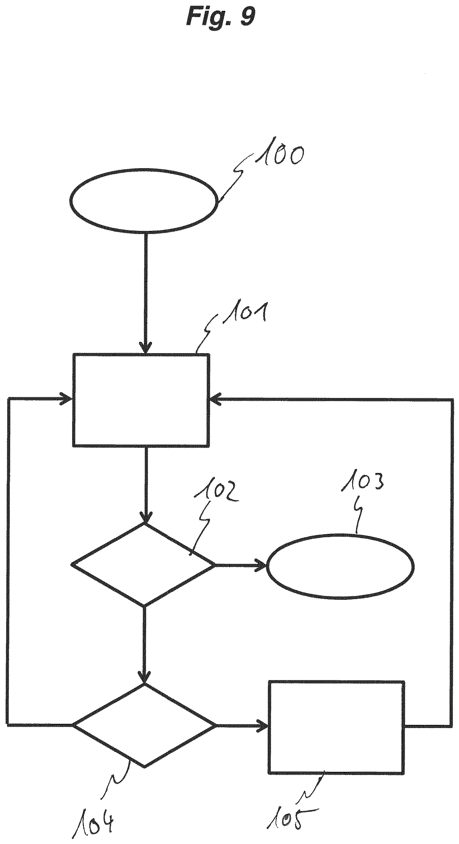

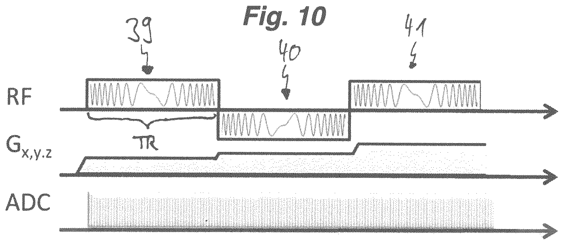

Fig. 9 zeigt in Form eines Flussdiagramms ein Ausführungsbeispiel eines erfindungsgemäßen Verfahrens zur MR-Untersuchung eines Messobjekts. Das Verfahren kann unter Verwendung der in Fig. 1 gezeigten HF-Einheit 1 ausgeführt werden. Ein Sequenzdiagramm einer MR-Messung, bei der das in Fig. 9 dargestellte Verfahren zur Anwendung kommen kann, ist in Fig. 10 dargestellt.

Zunächst findet in Schritt 100 eine Initialisierung des Verfahrens statt. In diesem Schritt werden Initialwerte für die Spannungen U_{ϕ} und U_{A} bestimmt, mit denen der Phasenmodulator 13 und der Amplitudenmodulator 14 zu Beginn der Messung betrieben werden sollen. Diese Werte können in einem Speicher hinterlegt sein oder auch im Wege einer Vormessung bestimmt werden. Hierbei wird sichergestellt, dass der dem Signalkombinierer 7 nachgeschaltete ultrarauscharme Signalverstärker 9 nicht gesättigt wird. Weiter werden Initialwerte für das Optimierungsverfahren festgelegt. Insbesondere werden initiale Schrittweiten festgelegt, d.h. im hier beschriebenen Ausführungsbeispiel die Spannungswerte ΔU_{ϕ} und ΔU_{A}. Diese Spannungswerte geben vor, dass nach der ersten Iteration des Optimierungsverfahrens U_{ϕ} um ΔU_{ϕ} und U_{A} um ΔU_{A} geändert werden. Ferner ist festzulegen, ob die initiale Änderung in positiver oder in negativer Richtung erfolgen soll, d.h., ob U_{ϕ,A} → U_{ϕ,A} + ΔU_{ϕ,A} oder ob U_{ϕ,A} → U_{ϕ,A} - ΔU_{ϕ,A}. Auch diese Initialwerte können vorgegeben sein oder im Wege einer Vormessung bestimmt werden.

Nach der Initialisierung 100 wird sodann in einem Schritt 101 ein erster Abschnitt 39 der von dem Anwender ausgewählten und dem Fachmann bekannten Messung mit einer Dauer von TR durchgeführt (vgl. Fig. 10). Hierzu wird ein Sendesignal der Dauer TR unter Anwendung bestimmter, für den Fachmann ermittelbarer Gradientenstärken G_{x,y.z} in das Messobjekt eingestrahlt und mit der Empfangsspule 6 aufgenommen. Von dem aufgenommenen Antwortsignal wird wie bereits oben beschrieben das mit ϕ und A modulierte Korrektursignal subtrahiert, verstärkt und digitalisiert. Die so ermittelten Messdaten werden einer Rekonstruktionseinheit zur Zwischenspeicherung und späteren Verwendung für die Rekonstruktion der gewünschten Information über das Messobjekt übermittelt. Die gleichen Messdaten werden auch an die Recheneinheit 11 übermittelt.

In einem nachfolgenden Schritt 102 wird überprüft, ob die Messung beendet ist. Dies ist der Fall, wenn die Messsequenz keine weiteren Messabschnitte 39, 40, 41 mehr vorsieht. In diesem Fall wird das Verfahren in Schritt 103 beendet. Hierzu werden insbesondere aus den der Rekonstruktionseinheit zugeführten Daten die vom Anwender gewünschte Information über das Messobjekt rekonstruiert, wie insbesondere ein MR-Bild.

Sofern die Messung nicht beendet ist, wird von der Recheneinheit 11 sodann der Schritt 104 ausgeführt. In diesem Schritt 104 wird überprüft, ob die Signalstärke des in Schritt 101 ermittelten Abschnitts des Messsignals 39, 40, 41 einen in Schritt 100 festgelegten Grenzwert überschreitet. Der Grenzwert kann hierbei wie bereits oben beschrieben bestimmt werden, indem beispielsweise jeweils eine Messung mit Messobjekt und ohne Messobjekt durchgeführt wird und eine Differenz des jeweiligen Messergebnisses gebildet wird und ein Aufschlag von beispielsweise 50 % auf diese Differenz aufgeschlagen wird. Die Signalstärke des Messabschnitts 39, 40, 41 wird ermittelt, indem die p2-Norm der in digitaler Form vorliegenden als Vektor aufgereiten Messdaten des Messabschnitts berechnet wird.

Sofern der Grenzwert nicht um 50% überschritten wird, wird davon ausgegangen, dass die aktuellen zur Korrektur verwendeten Werte von ϕ und A hinreichend optimal sind und die Messung wird in Schritt 101 fortgesetzt, indem der nachfolgende Messabschnitt 40, 41 durchgeführt wird.

Sobald jedoch und immer wenn im Verlauf der Messung der Grenzwert um mindestens 50% überschritten wird, wird vor der Aufnahme des nächsten Messabschnitts 40, 41 der Optimierungsschritt 105 ausgeführt. In diesem Schritt 105 werden zunächst neue Werte U_{ϕ} und U_{A} von der Recheneinheit 11 bestimmt. Hierzu wird zunächst die Signalintensität des aktuellen Messabschnitts 39, 40, 41 verglichen mit der Signalintensität des zuletzt aufgenommen Messabschnitts 39, 40, 41. Sollte sich die Signalintensität verringert haben, wird davon ausgegangen, dass die zuletzt vorgenommene Anpassung der Werte von U_{ϕ} und U_{A} zu einer Verbesserung der Qualität des Messsignals geführt hat, so dass die aktuellen Werte von U_{ϕ} und U_{A} auch in dem aktuellen Iterationsschritt erhöht werden, wenn zuvor eine Erhöhung stattgefunden hat und verringert werden, wenn zuvor eine Verringerung stattgefunden hat. Für den Fall einer Verschlechterung erfolgt eine Anpassung der Spanungswerte in umgekehrter Richtung. In dem hier beschriebenen Ausführungsbeispiel erfolgt die Anpassung der Spannungswerte U_{ϕ} und U_{A} mit den konstanten, initialen Schrittweiten ΔU_{ϕ} und ΔU_{A}. In einem alternativen Ausführungsbeispiel sind ΔU_{ϕ} und ΔU_{A} nicht konstant und werden nach einer bestimmten Vorschrift in jeder Iteration neu angepasst. Beispielsweise kann es zweckmäßig sein, wenn die Größen von ΔU_{ϕ} und ΔU_{A} davon abhängig sind, in welchem Maß der Grenzwert überschritten wird. Bei einer geringen Überschreitung können beispielsweise ΔU_{ϕ} und ΔU_{A} kleiner gewählt werden als bei einer starken Überschreitung.

Nachdem die neuen Werte Werte U_{ϕ} und U_{A} berechnet sind, werden diese Werte dem Gleichspannungs-Stromversorgungsmodul 12 übermittelt.

Sodann wird die Messung in Schritt 101 fortgesetzt, indem der nachfolgende Messabschnitt 40, 41 mit gemäß der jeweiligen Phasen-Spannungs-Kennlinie 23, 24 bzw. Dämpfungs-Spannungs-Kennlinie 32, 33 angepassten Werten für ϕ und A durchgeführt wird.

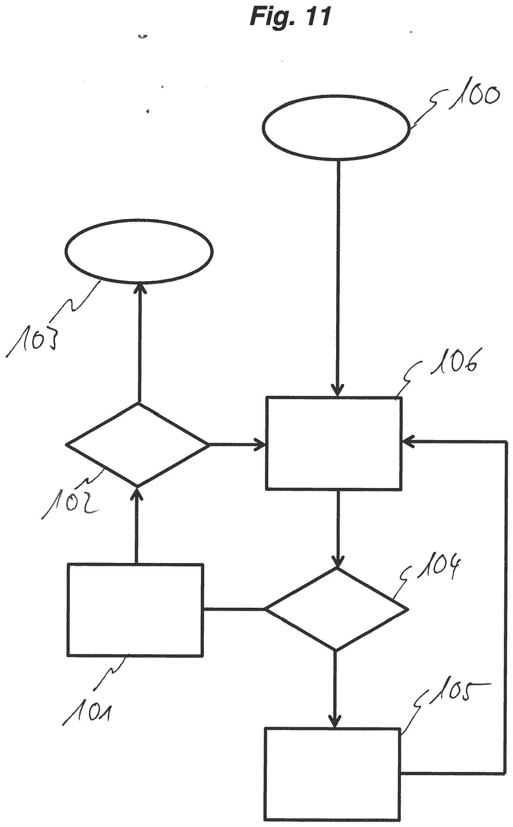

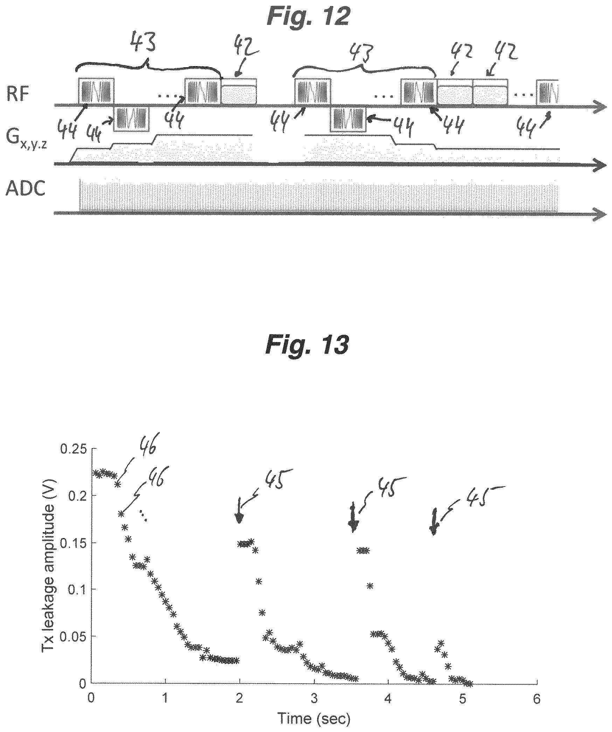

Fig. 11 zeigt ein alternatives Ausführungsbeispiel eines erfindungsgemäßen Verfahrens zur MR-Untersuchung eines Messobjekts. Auch dieses Verfahren kann unter Verwendung der in Fig. 1 gezeigten HF-Einheit 1 ausgeführt werden. Ein Sequenzdiagramm einer MR-Messung, bei der das in Fig. 11 dargestellte Verfahren zur Anwendung kommen kann, ist in Fig. 12 dargestellt. Im Unterschied zu dem in Fig. 9 dargestellten Verfahren, wird in dem in Fig. 11 dargestellten Verfahren die Korrektur von der eigentlichen Messung getrennt.

So wird nach einer Initialisierung 100 zunächst in Schritt 106 ein Überprüfungsschritt 106 eingefügt. In diesem Überprüfungsschritt 106 wird ein Überprüfungssignal 42 in das Messobjekt eingestrahlt und gemessen. Hierbei kann es sich insbesondere um einen on-resonanten Rechteckimpuls handeln. Sodann wird in Schritt 104 geprüft, ob die Signalstärke des in Schritt 106 aufgenommenen Abschnitts 42 des Messsignals einen zuvor festgelegten Grenzwert überschreitet. Ist dies der Fall, wird der Optimierungsschritt 105 ausgeführt und der Überprüfungsschritt 106 erneut ausgeführt. Dies erfolgt solange, bis der Grenzwert nicht mehr überschritten wird.

In einem alternativen Ausführungsbeispiel kann ein Abbruchkriterium definiert werden, beispielsweise durch Vorgabe einer maximalen Anzahl von Durchläufen der Schleife 104, 105, 106 oder einer beliebigen anderen Überprüfungsschleife, um zu vermeiden, dass sich das Verfahren in der Überprüfungsschleife verfängt. Beim Verlassen der Überprüfungsschleife würde das Messverfahren fortgesetzt werden, in Fig. 11 beispielsweise in Schritt 101, unter Verwendung der bislang erzielten Werte. Alternativ kann die Sendeleistung auch kurzfristig reduziert werden, um die Überprüfungsschleife erneut zu starten.

Nachdem in dem in Fig. 11 dargestellten Ausführungsbeispiel der Grenzwert nicht mehr überschritten wird, wird sodann in Schritt 101 der nächste zur Rekonstruktion der gewünschten Information über das Messobjekt vorgesehene Messabschnitt 43 aufgenommen und in Schritt 102 überprüft, ob die Messung abgeschlossen werden soll. Bei dem Messabschnitt 43 kann es sich um einen kurzen, lediglich einen Sendeimpuls 44 umfassenden Abschnitt handeln, aber auch um einen Abschnitt, der mehrere Sendeimpulse 44 umfasst. Soll die Messung abgeschlossen werden, wird die Messung in Schritt 103 beendet. Andernfalls wird erneut der Überprüfungsschritt 106 ausgeführt.

Bei dem hier beschriebenen Verfahren, aber auch generell bei einem erfindungsgemäßen Verfahren, kann es sich anbieten, keine über alle Iterationen konstanten Schrittweiten zu wählen, sondern diese anzupassen. So kann eine Anpassung wie bereits oben beschrieben in Abhängigkeit eines Grades einer Überschreitung des Grenzwerts erfolgen. Zweckmäßig kann jedoch auch sein, nach einem vorgegebenen Schema die Schrittweiten sukzessive zu verringern. Letzteres kann insbesondere dann vorteilhaft sein, wenn bei der Optimierung zunächst über mehrere Iterationsschritte lediglich die Phase ϕ angepasst wird und erst in einem nachfolgenden Schritt die Amplitude A angepasst wird. Auch eine Mischung der Methoden kann zweckmäßig sein, beispielsweise, wenn eine Anpassung von ϕ und A alternierend erfolgt, wobei jeweils eine oder mehrere Iterationen zur Anpassung von ϕ bzw. A gewählt werden können. In Fig. 13 ist die Signalstärke eines jeweiligen Messabschnitts ("Tx leakage amplitude") abgetragen gegenüber der Zeit ("Time"). Die Werte auf der y-Achse sind auf Volt bezogen, die Werte auf der x-Achse auf Sekunden. Zur Erzeugung der der Übersicht halber nur ausschnittsweise mit der Bezugsziffer 46 versehenen Messdaten wurde ein Verfahren verwendet, welches dem in Fig. 11 und Fig. 12 dargestellten Verfahren ähnlich ist. Allerdings wurde zur Überprüfung der Effektivität des Optimierungsverfahrens absichtlich ein niedriger Grenzwert gewählt, so dass das Verfahren nicht aus der Schleife 106, 104, 105 ausbrechen konnte. Zu den mit einem Pfeil 45 angedeutete Zeitpunkten führte der untersuchte Proband jeweils eine Handbewegung aus. Aufgrund der sich dadurch ändernden Kopplung der Empfangsspule 6 und der Sendespule 5 mussten jeweils neue optimale Werte für ϕ und A ermittelt werden. Aus Fig. 13 ist ersichtlich, dass das verwendete Optimierungsverfahren mit einer Feedback-Zeit von 50 ms zwischen wenigen hundert Millisekunden bis zu wenigen Sekunden benötigte, um zu konvergieren, was einer Anzahl von wenigen Iterationen bis zu etwa 40 Iterationen entspricht. Alternativ können auch andere Feedback-Zeiten verwendet werden, beispielsweise von 5 ms.

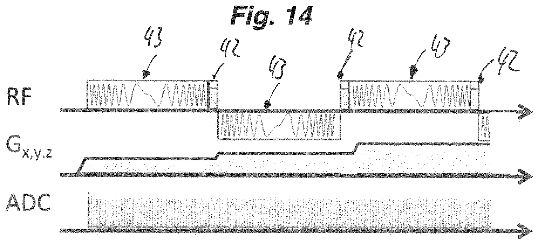

Fig. 14 zeigt ein alternatives Sequenzdiagramm einer MR-Messung einer erfindungsgemäßen MR-Untersuchung. Hier wird in die Messsequenz am Ende jedes Messabschnitts 43 jeweils ein kurzes, wenige Mikrosekunden andauerndes Überprüfungssignal 42 eingestrahlt und gemessen. Im Unterschied zu dem in Fig. 11 dargestellten Verfahren wird hier nicht abgewartet, bis Konvergenz erreicht ist, sondern es wird ähnlich wie bei dem in Fig. 9 dargestellten Verfahren eine Korrektur kontinuierlich und die Messung unterbrechungsfrei angewandt. Im Unterschied zu dem in Fig. 9 dargestellten Verfahren werden allerdings nicht die zur Rekonstruktion aufgenommenen Messdaten zur Korrektur des Antwortsignals verwendet, sondern es werden speziell für die Korrektur entwickelte Überprüfungsimpulse verwendet. Da diese Impulse sehr kurz sind, besteht weiterhin eine nahezu optimale Akquisitionseffizienz.

Bei jedem der beschriebenen Ausführungsbeispiele kann der Analog-Digital-Wandler 10 unterbrechungsfrei eingeschaltet bleiben und kontinuierlich Messdaten aufnehmen (vgl. Fig. 10, 12 und 14, Zeile "ADC"). Dies ist vorteilhaft, für die Erfindung jedoch nicht zwingend notwendig. Unterschiede bestehen allerdings wie bereits oben beschrieben, ob und welche der Messdaten von dem Optimierungsverfahren und/oder für die Rekonstruktion der gewünschten Information über das Messobjekt verwendet werden.

Es wird ein Verfahren zur Magnetresonanzuntersuchung eines Messobjekts beschrieben, wobei eine Messsequenz verwendet wird, bei der die Magnetresonanzantwort auf das Sendesignal während des Sendens gemessen wird. Es wird vorgeschlagen, ein dem Sendesignal korrespondierendes Korrektursignal zu erzeugen und zur Korrektur des Antwortsignals zu verwenden. Hierzu wird das Korrektursignal durch einen Phasenwert und einen Amplitudenwert moduliert. Der Phasenwert und der Amplitudenwert werden unter Verwendung eines jeweils aktuellen Zustandswerts des Messsignals automatisch und iterativ mittels eines Optimierungsverfahrens zur optimalen Korrektur des Antwortsignals angepasst. Weiter wird eine Hochfrequenzeinheit 1 beschrieben, mit der das erfindungsgemäße Verfahren ausführbar ist.

### Bezugszeichenliste

- 1: HF-Einheit
- 2: HF-Generator
- 3: Signalverstärker
- 4: Signalteiler
- 5: Sendespule
- 6: Empfangsspule
- 7: Signalkombinierer
- 8: Modulator
- 9: weiterer Signalverstärker
- 10: Analog-Digital-Wandler
- 11: Recheneinheit
- 12: Gleichspannungs-Stromversorgungsmodul
- 13: Phasenmodulator
- 14: Amplitudenmodulator
- 15: 90°-Hybridkoppler
- 16: erster Anschluss von 15
- 17: zweiter Anschluss von 15
- 18: dritter Anschluss von 15
- 19: vierter Anschluss von 15
- 20: Varaktordiode
- 21: weitere Varaktordiode
- 22: Gleichspannungsquelle
- 23: Phasen-Spannungs-Kennlinie
- 24: weitere Phasen-Spannungs-Kennlinie
- 25: ersten Anschluss von 14
- 26: zweiter Anschluss von 14
- 27: Gleichspannungsquelle
- 28: weitere Gleichspannungsquelle
- 29: pin-Diode
- 30: weitere pin-Diode
- 31: weitere pin-Diode
- 32: Dämpfungs-Spannungs-Kennlinie
- 33: weitere Dämpfungs-Spannungs-Kennlinie
- 34: Hybridkoppler
- 35: pin-Diode
- 36: weitere pin-Diode
- 37: Widerstand
- 38: weiterer Widerstand
- 39: erster Abschnitt einer Messung
- 40: Abschnitt einer Messung
- 41: weiterer Abschnitt einer Messung
- 42: Überprüfungssignal
- 43: Messabschnitt
- 44: Sendeimpuls
- 45: Pfeil
- 46: Messdatum

## Patentansprüche

1. Verfahren zur Magnetresonanzuntersuchung eines Messobjekts, wobei ein Sendesignal in das Messobjekt eingestrahlt wird, ein Antwortsignal, welches in Reaktion auf das Sendesignal von dem Messobjekt ausgestrahlt wird, aufgenommen wird, wobei das Antwortsignal zumindest zeitweilig während eines Einstrahlzeitraums des Sendesignals aufgenommen wird, ein Messsignal durch Korrektur des Antwortsignals erzeugt wird und eine Information über das Messobjekt aus dem Messsignal rekonstruiert wird,
ein dem Sendesignal korrespondierendes Korrektursignal erzeugt und zur Korrektur des Antwortsignals verwendet wird, wobei das Korrektursignal durch einen Phasenwert und einen Amplitudenwert moduliert wird **dadurch gekennzeichnet, dass** folgende Schritte zur Korrektur des Antwortsignals automatisch iterativ ausgeführt werden:
∘ Ermitteln eines aktuellen Zustandswerts des Messsignals,
∘ sodann Ermitteln eines aktuellen Phasenwertes und/oder eines aktuellen Amplitudenwertes für das Korrektursignal unter Verwendung eines Optimierungsverfahrens, wobei das Optimierungsverfahren den aktuellen Zustandswert des Messsignals als Input verwendet,
∘ sodann Modulieren eines einem aktuellen Abschnitt des Sendesignals korrespondierenden aktuellen Abschnitts des Korrektursignals mit dem aktuellen Phasenwert und/oder dem aktuellen Amplitudenwert,
∘ sodann Erzeugung eines aktuellen Abschnitts des Messsignals durch Subtraktion des aktuellen Abschnitts des Korrektursignals von einem zeitgleich zum Einstrahlen des aktuellen Abschnitts des Sendesignals aufgenommenen aktuellen Abschnitt des Antwortsignals.

2. Verfahren nach Anspruch 1, **dadurch gekennzeichnet, dass** der Zustandswert des Messsignals ein Maß für einen Sendesignalanteil und/oder eine Signalstärke in dem Messsignal ist.

3. Verfahren nach einem der Ansprüche 1 oder 2, **dadurch gekennzeichnet, dass** das Optimierungsverfahren mindestens einen weiteren zuvor, insbesondere zuletzt, ermittelten Zustandswert des Messsignals als Input verwendet und/oder dass der jeweils aktuelle Phasenwert und/oder Amplitudenwert mittels eines Gradientenverfahrens ermittelt wird, insbesondere wobei in jeder Iteration eine Größe, von der der Phasenwert und/oder der Amplitudenwert abhängt, verändert wird, wobei weiterhin ausgelesen wird, in welcher Richtung die Größe in einer vorherigen Iteration verändert worden ist, wobei weiterhin für eine Veränderung der Größe eine Schrittweite gewählt wird, wobei weiterhin der aktuelle Zustandswert des Messsignals mit einem oder dem zuvor ermittelten Zustandswert verglichen wird und für den Fall einer Verbesserung des Zustandswerts die Veränderung der Größe in der ausgelesenen Richtung erfolgt und für den Fall einer Verschlechterung des Zustandswert die Veränderung der Größe in einer der ausgelesenen Richtung entgegengesetzten Richtung erfolgt.

4. Verfahren nach einem der vorherigen Ansprüche, **dadurch gekennzeichnet, dass** das Antwortsignal vollständig während des Einstrahlzeitraums des Sendesignals aufgenommen wird und/oder dass die Information über das Messobjekts aus dem Messsignal rekonstruiert wird, indem mindestens 90%, vorzugsweise 100%, einer gesamten Aufnahmedauer des Messsignals verwertet wird.

5. Verfahren nach einem der vorherigen Ansprüche, **dadurch gekennzeichnet, dass** das Modulieren des dem aktuellen Abschnitt des Sendesignals korrespondierenden aktuellen Abschnitts des Korrektursignals mit dem aktuellen Phasenwert und/oder dem aktuellen Amplitudenwert spannungsgesteuert erfolgt, insbesondere unter Verwendung eines spannungsgesteuert verstellbaren Phasenmodulators (13) und/oder Amplitudenmodulators (14) und/oder unter Verwendung einer digitalen Spannungssteuerung.

6. Verfahren nach einem der vorherigen Ansprüche, **dadurch gekennzeichnet, dass** zur Verstärkung des Messsignals ein Signalverstärker (9) verwendet wird, wobei der Signalverstärker (9) eine dynamische Bandbreite hat, welche außerhalb einer Signalstärke des amplitudenmodulierten Korrektursignals liegt.

7. Verfahren nach einem der vorherigen Ansprüche, **dadurch gekennzeichnet, dass** zunächst der Zustandswert des Messsignals geprüft wird und dass bei Überschreiten eines ersten Grenzwertes die zur Korrektur des Antwortsignals durchzuführenden Schritte ausgeführt werden bis der Zustandswert des Messsignals einen zweiten Grenzwert erreicht hat, insbesondere wobei der zweite Grenzwert mit dem ersten Grenzwert identisch ist und/oder wobei der erste und/oder der zweite Grenzwert größer ist als ein Schätzwert für einen maximalen Zustandswerts des Messsignals.

8. Verfahren nach einem der vorherigen Ansprüche, **dadurch gekennzeichnet, dass** der jeweils aktuelle Abschnitt des Messsignals auch zur Rekonstruktion der Information über das Messobjekt verwendet wird.

9. Verfahren nach einem der Ansprüche 1 bis 7, **dadurch gekennzeichnet, dass** der jeweils aktuelle Abschnitt des Messsignals nicht zur Rekonstruktion der Information über das Messobjekt verwendet wird, insbesondere wobei der jeweils aktuelle Abschnitt des Messsignals eine Dauer aufweist, welche einer Impulsdauer oder weniger als ein Zehntel einer Impulsdauer eines Sendesignals entspricht, wobei das Sendesignal in das Messobjekt eingestrahlt wird, um einen zur Rekonstruktion verwendeten Abschnitt eines Messsignals zu erzeugen.

10. Verfahren nach einem der vorherigen Ansprüche, **dadurch gekennzeichnet, dass** für den Fall, dass der aktuelle Zustandswert des Messsignals einen dritten Grenzwert überschreitet, der zuletzt erzeugte Abschnitt des Messsignals erneut erzeugt wird.

11. Verfahren nach einem der vorherigen Ansprüche, **dadurch gekennzeichnet, dass** ein on-resonanter Impuls, insbesondere Rechteckimpuls, in das Messobjekt eingestrahlt wird, um den aktuellen Abschnitt des Messsignals zu erzeugen.

12. Hochfrequenzeinheit (1) eines Magnetresonanzgeräts mit
- einem Generator (2) zur Generierung eines Hochfrequenzsignals
- einem Signalteiler (4), der einen Signaleingang hat, welcher mit einem Ausgang des Generators (2) in Wirkverbindung steht, und der einen ersten Ausgang und einen zweiten Ausgang aufweist,
- einer Sendespule (5), mit der ein Sendesignal erzeugbar ist und die mit dem ersten Ausgang des Signalteilers (4) in Wirkverbindung steht,
- einer Empfangsspule (6), mit der ein ein Magnetresonanzsignal bildendes Antwortsignal von einem Messobjekt aufnehmbar ist,
- einem Modulator (8), der mit dem zweiten Ausgang des Signalteilers (4) in Wirkverbindung steht, wobei der Modulator (8) einen Phasenmodulator (13) und/oder einen Amplitudenmodulator (14) umfasst,
- einem Signalkombinierer (7), welcher mit der Empfangsspule (6) und dem Modulator (8) in Wirkverbindung steht und mit dem ein Messsignal erzeugbar ist,
**dadurch gekennzeichnet, dass**
- die Hochfrequenzeinheit eine Steuereinheit (11) umfasst, die mit dem Signalkombinierer (7) und dem Modulator (8) in Wirkverbindung steht und dass die Hochfrequenzeinheit (1) dazu ausgebildet ist, das Verfahren nach einem der vorherigen Ansprüche auszuführen.

## Claims

1. A method for the magnetic resonance examination of a measurement object, wherein a transmitted signal is radiated into the measurement object, a response signal emitted by the measurement object in reaction to the transmitted signal is picked up, the response signal being at least intermittently picked up during a period of radiation of the transmitted signal, a measurement signal is generated by correction of the response signal and a piece of information about the measurement object is reconstructed from the measurement signal,
a correction signal corresponding to the transmitted signal is generated and is used for correction of the response signal, the correction signal being modulated by a phase value and an amplitude value, **characterized in that** the following steps for correction of the response signal are automatically carried out iteratively:
o ascertaining a present state value of the measurement signal,
o thereupon ascertaining a present phase value and/or a present amplitude value for the correction signal using an optimization method, the optimization method using the present state value of the measurement signal as input,
o thereupon modulating a present section of the correction signal that corresponds to a present section of the transmitted signal with the present phase value and/or the present amplitude value,
o thereupon generating a present section of the measurement signal by subtraction of the present section of the correction signal from a present section of the response signal that is picked up at the same time as the present section of the transmitted signal is radiated.

2. Method according to Claim 1, **characterized in that** the state value of the measurement signal is a measure of a transmitted signal component and/or a signal strength in the measurement signal.

3. Method according to either of Claims 1 and 2,
**characterized in that** the optimization method uses at least one further previously, in particular most recently, ascertained state value of the measurement signal as input and/or **in that** the respective present phase value and/or amplitude value is ascertained by means of a gradient method, in particular wherein, in each iteration, a variable on which the phase value and/or the amplitude value is dependent is altered, wherein, in addition, the direction in which the variable has been altered in a previous iteration is read, wherein, in addition, a step size is chosen for an alteration of the variable, wherein, in addition, the present state value of the measurement signal is compared with a or the previously ascertained state value and the variable is altered in the read direction in the event of an improvement in the state value and the variable is altered in a direction opposite to the read direction in the event of a worsening of the state value.

4. Method according to one of the preceding claims,
**characterized in that** the response signal is picked up completely during the period of radiation of the transmitted signal and/or **in that** the information about the measurement object is reconstructed from the measurement signal by virtue of at least 90%, preferably 100%, of a total pickup time of the measurement signal being used.

5. Method according to one of the preceding claims,
**characterized in that** the modulating of the present section of the correction signal that corresponds to the present section of the transmitted signal with the present phase value and/or the present amplitude value is effected in voltage-controlled fashion, particularly using a phase modulator (13) and/or amplitude modulator (14) adjustable in voltage-controlled fashion and/or using a digital voltage controller.

6. Method according to one of the preceding claims,
**characterized in that** the measurement signal is amplified using a signal amplifier (9), the signal amplifier (9) having a dynamic bandwidth that is outside a signal strength of the amplitude-modulated correction signal.

7. Method according to one of the preceding claims,
**characterized in that** first the state value of the measurement signal is checked and **in that**, in the event of a first limit value being exceeded, the steps that are to be performed for correction of the response signal are carried out until the state value of the measurement signal has reached a second limit value, in particular wherein the second limit value is identical to the first limit value and/or wherein the first and/or the second limit value is greater than an estimate of a maximum state value of the measurement signal.

8. Method according to one of the preceding claims,
**characterized in that** the respective present section of the measurement signal is also used for reconstruction of the information about the measurement object.

9. Method according to one of Claims 1 to 7, **characterized in that** the respective present section of the measurement signal is not used for reconstruction of the information about the measurement object, in particular wherein the respective present section of the measurement signal has a duration that corresponds to a pulse duration or to less than one tenth of a pulse duration of a transmitted signal, the transmitted signal being radiated into the measurement object in order to generate a section of a measurement signal that is used for reconstruction.

10. Method according to one of the preceding claims,
**characterized in that** in the event of the present state value of the measurement signal exceeding a third limit value, the most recently generated section of the measurement signal is generated again.

11. Method according to one of the preceding claims,
**characterized in that** an on-resonant pulse, particularly a square-wave pulse, is radiated into the measurement object in order to generate the present section of the measurement signal.

12. Radio-frequency unit (1) of a magnetic resonance imaging scanner having
- a generator (2) for generating a radio-frequency signal,
- a signal divider (4) that has a signal input operatively connected to an output of the generator (2) and that has a first output and a second output,
- a transmission coil (5) that can be used to generate a transmitted signal and that is operatively connected to the first output of the signal divider (4),
- a reception coil (6) that can be used to pick up a response signal forming a magnetic resonance signal from a measurement object,
- a modulator (8) that is operatively connected to the second output of the signal divider (4), the modulator (8) comprising a phase modulator (13) and/or an amplitude modulator (14),
- a signal combiner (7) that is operatively connected to the reception coil (6) and the modulator (8) and that can be used to generate a measurement signal,
**characterized in that**
- the radio-frequency unit comprises a control unit (11) that is operatively connected to the signal combiner (7) and the modulator (8) and **in that** the radio-frequency unit (1) is configured to carry out the method according to one of the preceding claims.

## Revendications

1. Procédé pour l'examen par résonance magnétique d'un objet de mesure, dans lequel un signal d'émission est envoyé par rayonnement dans l'objet de mesure, dans lequel un signal de réponse, qui est émis par l'objet de mesure en réponse au signal d'émission, est reçu, dans lequel le signal de réponse est reçu au moins temporairement pendant une période de rayonnement du signal d'émission, dans lequel un signal de mesure est produit par correction du signal de réponse, dans lequel une information relative à l'objet de mesure est reconstruite à partir du signal de mesure, dans lequel un signal de correction qui correspond au signal d'émission est produit et utilisé pour corriger le signal de réponse et dans lequel le signal de correction est modulé par une valeur de phase et une valeur d'amplitude, **caractérisé en ce que** les étapes suivantes sont exécutées de façon automatiquement itérative pour la correction du signal de réponse :
- déterminer une valeur d'état actuelle du signal de mesure,
- déterminer ensuite une valeur de phase actuelle et/ou une valeur d'amplitude actuelle pour le signal de correction au moyen d'un procédé d'optimisation, dans lequel le procédé d'optimisation utilise la valeur d'état actuelle du signal de mesure comme entrée,
- moduler ensuite une partie actuelle du signal de correction qui correspond à une partie actuelle du signal d'émission avec la valeur de phase actuelle et/ou la valeur d'amplitude actuelle, et
- produire ensuite une partie actuelle du signal de mesure en soustrayant la partie actuelle du signal de correction d'une partie actuelle du signal de réponse reçue en même temps que le rayonnement de la partie actuelle du signal d'émission.

2. Procédé selon la revendication 1, **caractérisé en ce que** la valeur d'état du signal de mesure est une mesure d'une part de signal d'émission et/ou une intensité de signal dans le signal de mesure.

3. Procédé selon l'une quelconque des revendications 1 ou 2, **caractérisé en ce que** le procédé d'optimisation utilise au moins une autre valeur d'état du signal de mesure préalablement déterminée, en particulier en dernier, comme entrée, et/ou **en ce que** la valeur de phase et/ou la valeur d'amplitude respectivement actuelle(s) est (sont) déterminée(s) à l'aide d'un procédé de gradient, en particulier dans lequel, lors de chaque itération, une grandeur, dont la valeur de phase et/ou la valeur d'amplitude dépend(ent), est modifiée, dans lequel il est en outre lu la direction dans laquelle la grandeur a été modifiée lors d'une itération précédente, dans lequel un incrément est en outre sélectionné en vue d'une modification de la grandeur, dans lequel la valeur d'état actuelle du signal de mesure est en outre comparée à une ou à la valeur d'état préalablement déterminée et, dans le cas d'une amélioration de la valeur d'état, la modification de la grandeur s'effectue dans la direction lue et, dans le cas d'une détérioration de la valeur d'état, la modification de la grandeur s'effectue dans une direction opposée à la direction lue.

4. Procédé selon l'une quelconque des revendications précédentes, **caractérisé en ce que** le signal de réponse est reçu entièrement pendant la période de rayonnement du signal d'émission et/ou **en ce que** l'information relative à l'objet de mesure est reconstruite à partir du signal de mesure, du fait qu'au moins 90 %, et de préférence 100 %, d'une durée de réception totale du signal de mesure sont exploités.

5. Procédé selon l'une quelconque des revendications précédentes, **caractérisé en ce que** la modulation de la partie actuelle du signal de correction qui correspond à la partie actuelle du signal d'émission avec la valeur de phase actuelle et/ou la valeur d'amplitude actuelle s'effectue de manière commandée en tension, en particulier à l'aide d'un modulateur de phase (13) et/ou d'un modulateur d'amplitude (14) réglable(s) de manière commandée en tension et/ou à l'aide d'une commande de tension numérique.

6. Procédé selon l'une quelconque des revendications précédentes, **caractérisé en ce que**, pour amplifier le signal de mesure, on utilise un amplificateur de signal (9), dans lequel l'amplificateur de signal (9) présente une bande passante dynamique qui se situe à l'extérieur d'une intensité de signal du signal de correction modulé en amplitude.

7. Procédé selon l'une quelconque des revendications précédentes, **caractérisé en ce que** la valeur d'état de signal de mesure est tout d'abord contrôlée, et **en ce que**, lorsqu'une première valeur limite est dépassée, les étapes à réaliser pour la correction du signal de réponse sont exécutées jusqu'à ce que la valeur d'état du signal de mesure ait atteint une deuxième valeur limite, en particulier dans lequel la deuxième valeur limite est identique à la première valeur limite et/ou dans lequel la première et/ou la deuxième valeur limite est (sont) plus grande(s) qu'une valeur d'estimation pour une valeur d'état maximale du signal de mesure.

8. Procédé selon l'une quelconque des revendications précédentes, **caractérisé en ce que** la partie respectivement actuelle du signal de mesure est également utilisée pour la reconstruction de l'information relative à l'objet de mesure.

9. Procédé selon l'une quelconque des revendications 1 à 7, **caractérisé en ce que** la partie respectivement actuelle du signal de mesure n'est pas utilisée pour la reconstruction de l'information relative à l'objet de mesure, en particulier dans lequel la partie respectivement actuelle du signal de mesure présente une durée qui correspond à une durée d'impulsion ou à moins d'un dixième d'une durée d'impulsion d'un signal d'émission, dans lequel le signal d'émission est envoyé par rayonnement dans l'objet de mesure dans le but de produire une partie d'un signal de mesure utilisée pour la reconstruction.

10. Procédé selon l'une quelconque des revendications précédentes, **caractérisé en ce qu'**au cas où la valeur d'état actuelle du signal de mesure dépasserait une troisième valeur limite, la partie du signal de mesure produite en dernier est de nouveau produite.

11. Procédé selon l'une quelconque des revendications précédentes, **caractérisé en ce qu'**une impulsion en résonance, en particulier une impulsion rectangulaire, est envoyée par rayonnement dans l'objet de mesure dans le but de produire la partie actuelle du signal de mesure.

12. Unité haute fréquence (1) d'un appareil à résonance magnétique, comprenant :
- un générateur (2) pour générer un signal haute fréquence,
- un diviseur de signal (4) qui présente une entrée de signal qui se trouve en liaison fonctionnelle avec une sortie du générateur (2) et qui présente une première sortie et une deuxième sortie,
- une bobine émettrice (5), avec laquelle un signal d'émission peut être produit et qui se trouve en liaison fonctionnelle avec la première sortie du diviseur de signal (4) ,
- une bobine réceptrice (6) à l'aide de laquelle un signal de réponse qui forme un signal de résonance magnétique peut être reçu par un objet de mesure,
- un modulateur (8) qui se trouve en liaison fonctionnelle avec la deuxième sortie du diviseur de signal (4), dans lequel le modulateur (8) comprend un modulateur de phase (13) et/ou un modulateur d'amplitude (14), et
- un combineur de signal (7) qui se trouve en liaison fonctionnelle avec la bobine réceptrice (6) et le modulateur (8) et à l'aide duquel un signal de mesure peut être produit,
**caractérisé en ce que** l'unité haute fréquence comprend une unité de commande (11) qui se trouve en liaison fonctionnelle avec le combineur de signal (7) et le modulateur (8) et **en ce que** l'unité haute fréquence (1) est réalisée dans le but d'exécuter le procédé selon l'une quelconque des revendications précédentes.
